# EUROPEAN PATENT APPLICATION

(11) **EP 2 272 617 A1**
(43) Date of publication of application: **12.01.2011**
(21) Application number: 09724803.3
(22) Date of filing: 19.03.2009
(51) Int. Cl.: B23K 26/10, B23K 26/00, B23K 26/14, B23K 26/42, H05K 3/00, H05K 3/08

(54) **BEAM PROCESSING APPARATUS, BEAM PROCESSING METHOD, AND BEAM PROCESSING SUBSTRATE**

(30) Priority: 24.03.2008 JP 2008075067; 27.08.2008 JP 2008217849; 18.03.2009 JP 2009067020
(71) Applicant: Marubun Corporation, Chuo-ku Tokyo 103-8577 (JP)
(72) Inventor: NAKADA, Satoki, Tokyo 103-8577 (JP); YAMAOKA, Hiroshi, Tokyo 103-8577 (JP); KINOMOTO, Ryo, Tokyo 103-8577 (JP)
(74) Representative: HOFFMANN EITLE
(86) International application number: PCT/JP2009/055499
(87) International publication number: WO 2009/119457

(57) **Abstract**

A beam processing apparatus is provided in which a beam is irradiated to a layer 3 to be processed which is formed on one surface of a substrate 2, thereby to process the layer. The apparatus has a gas floating mechanism 10 that supports the substrate in flatly-floated state by ejecting gas, and a beam irradiation unit 50 that irradiates a beam to the layer 3 which is formed on one surface of the substrate 2, thereby to process the layer 3. The substrate 2 is arranged on the gas floating mechanism 10 with one surface of the substrate 2 on which the layer 3 is formed being directed downwards. Then, processing is applied to the layer 3 by irradiating a beam on the layer 3 through the substrate 2 by means of the beam irradiation unit 50 from above the other surface of the substrate 2.

## Description

### TECHNICAL FIELD

The present invention relates to a beam processing apparatus, a beam processing method, and a beam processed substrate having a layer (thin film) to be processed which has been processed by the beam processing apparatus, which can be suitably used in cases where a thin film forming a semiconductor device is patterned by a beam (laser, etc.), at the time of forming, on a substrate such as a glass substrate, a semiconductor device used as a power generation system which makes use of a photoelectric effect, for example.

### BACKGROUND ART

In general, in the production of the above-mentioned power generation system using a silicon-based amorphous film, a transparent electrode (for example, indium oxide, tin oxide, zinc oxide, etc.) layer is first formed and patterned on a large glass substrate, and subsequently, an amorphous silicon layer (photoelectric conversion layer) is formed and patterned on the glass substrate, after which a metal electrode is formed and patterned on the glass substrate.
There has been established a method of performing each patterning in this case by means of laser patterning using a laser beam, but not a wet type one.

The laser patterning here is to divide the individual thin film layers formed on the glass substrate in a sequential manner into a lot of battery cells by sequentially forming grooves (slits) in the individual thin film layers, respectively, so that the thin film layers are electrically insulated from one another by the grooves which act as borders, and it is also called laser scribing.
In such laser scribing, the grooves are formed by irradiating a transparent electrode layer formed on the glass substrate with a laser beam from a glass substrate side (for example, see a first patent document).

That is, the laser beam is irradiated not from a surface side of the glass substrate at which a layer to be processed is formed, but from an opposite side thereof. In this case, for example, when it is constructed such that a laser beam is irradiated from above the glass substrate, the glass substrate is placed on a table, for example, in a state where the layer to be processed is arranged at an under side. In this case, the layer to be processed contacts a table upper surface, so the layer to be processed may be damaged, or may be affected by the influences of the table (for example, temperature, reflection of the laser) at the time of processing.

Accordingly, the glass substrate is supported on its periphery so as to be placed in a hung state, and laser is irradiated thereon from above.
In this case, the glass substrate is conveyed in one direction in the state of being hung from the periphery thereof, and the irradiation position of the laser is moved in a direction substantially orthogonal to the conveyance direction of the glass substrate, whereby the grooves are formed in a stripe shape in the layer to be processed on the glass substrate.

First Patent Document: Japanese patent application laid-open No. 2006-54254

### DISCLOSURE OF THE INVENTION

### PROBLEMS TO BE SOLVED BY THE INVENTION

Incidentally, in the production of power generation systems making use of a photoelectric effect, in the production of panel displays such as plasma displays, and the like, the enlargement of a glass substrate is advanced for cost reduction.
At the time of enlarging the glass substrate, the thickness of the glass substrate is not basically made thicker, so when the enlarged glass substrate is supported at its periphery, the glass substrate will bend downwards to a large extent. As a result of this, the height positions of the right and left side portions of the glass substrate will greatly differ from the height position of the central portion thereof between the right and left side portions.

In addition, upon irradiation of a laser, the laser will be condensed or imaged on a layer to be processed by means of an optical element. In cases where the height or vertical position of the glass substrate changes greatly depending upon the individual locations of the glass substrate as described above, even if the optical element is focused on any place of the glass substrate which becomes a position to be irradiated at the time when the laser is irradiated from above, the focus will shift when the position to be irradiated is moved.

Accordingly, in the past, in a laser beam processing apparatus for laser scribing, there is provided, for example, an auto-focusing mechanism for always focusing a laser beam onto a glass substrate. That is, by measuring the height or vertical position (i.e., the distance from an objective lens as an optical element) of a laser irradiation position of the glass substrate which bends as mentioned above, and moving the objective lens as the optical element up and down based on the result of the measurement, the objective lens has been moved up and down in such a manner that the layer to be processed always falls into the focal range of the optical element.

Here, the direction (right and left direction) in which the glass substrate bends to curve, and the direction of movement (right and left direction) of the irradiation position of the laser are in match with each other, so the objective lens is moved up and down so as to always adjust the focal position thereof during the course of processing.
Accordingly, it is impossible to continue laser scribing without changing the height position of the objective lens after the height position of the objective lens has been adjusted at the time of the start of the laser scribing.

Due to the provision of such an auto-focusing mechanism, the structure of the laser beam processing apparatus to perform laser scribing has been complicated, and at the same time the cost of production thereof has been high. In addition, there is a possibility that at the time of performing laser scribing, the measurement of the height position of the layer to be processed and the accompanying change of the height position of the objective lens may become a bottleneck for the operating speed of the laser scribing operation, and in this case, an enhancement in speed of the laser scribing operation will be inhibited by the auto-focusing mechanism.
In addition, when laser scribing is performed, there will be generated powder of substances which constitute the layer to be processed, and which have been sublimated or liquefied at the time of forming the grooves and then solidified, or powder thereof which has been exfoliated by the laser. As described above, if the glass substrate is in a state of being hung in the air with the layer to be processed being disposed at a lower side, it will not be in a state where powder generated by laser processing falls down on the glass substrate, but it will be in a state where the powder falls and accumulates at a lower side of the glass substrate.
As a result of this, in the beam processing apparatus, cleaning is frequently required.

The present invention has been made in view of the above-mentioned circumstances, and has for its object to provide a beam processing apparatus, a beam processing method, and a beam processed substrate having a layer to be processed that has been processed by means of the beam processing apparatus, in which there is no need to always adjust the focal position of a beam by auto-focusing.

### MEANS FOR SOLVING THE PROBLEMS

A beam processing apparatus as set forth in claim 1 resides in a beam processing apparatus which irradiates a beam to a layer to be processed which is formed on one surface of a substrate, thereby to process the layer, and is characterized by comprising:
a gas floating mechanism that supports the substrate in a flatly floated state by ejecting a gas; and
a beam irradiation unit that irradiates a beam to the layer to be processed which is formed on one surface of the substrate, thereby to process the layer to be processed;
wherein the substrate is arranged on the gas floating mechanism with one surface of the substrate on which the layer to be processed is formed being directed downwards, and processing is applied to the layer to be processed by irradiating a beam on the layer to be processed through the substrate by means of the beam irradiation unit from above the other surface of the substrate.

In the invention as set forth in claim 1, the substrate is supported by the gas floating mechanism in a flatly floated state with the layer to be processed being directed downwards, so that the entire substrate is supported by the ejecting gas. With such an arrangement, it is possible to prevent the substrate from being bent under its own weight. Accordingly, the beam is irradiated to the substrate in a state where the substrate is supported in a substantially planar or flat state without being bent, by means of the gas floating mechanism, so the irradiation position of the beam does not shift up and down to any great extent depending upon the position of the substrate.

Accordingly, even if the irradiation position of the beam moves relatively with respect to the substrate, it becomes possible to include the layer to be processed within a focal range of the beam without changing the focal position thereof, and hence, for example, at the start of beam irradiation or at the time of maintenance, etc., by adjusting the focal position of the beam at one time, it becomes unnecessary to change the focal position of the beam at any time during operation.
As a result of this, an auto-focusing mechanism can be omitted, whereby it is possible to reduce the cost of the beam processing apparatus to a substantial extent, and at the same time, it is also possible to simplify the structure of a focusing part of an objective optical device in the beam processing apparatus to a great extent.

In addition, since there is no auto-focusing mechanism, a delay of operation due to the control of an auto-focusing mechanism does not occur, thus making it possible to eliminate a hindrance at the time of achieving the speed up of operation.
Even in cases where the layer to be processed of the substrate is arranged at a lower side, the layer to be processed is out of contact with the stage, etc., with a gas layer being formed between itself and the stage, so it is possible to prevent damage due to contact of the layer to be processed as well as to prevent the layer to be processed by the beam from being affected by the influence of the stage. For example, the influence of the temperature of the stage, the reflection of the beam, etc., can be suppressed.

A beam processing apparatus as set forth in claim 2 is characterized in that in the beam processing apparatus as set forth in claim 1,
the gas floating mechanism is provided with a stage that has a gas ejection mechanism for ejecting a gas, and supports the substrate by floating it in a flat state, and a moving mechanism that moves the substrate in at least one direction on the stage;
the beam irradiation unit has an irradiation position of the beam which is made reciprocatable along one direction intersecting one direction of movement of the substrate;
the stage is provided with a powder removing unit that sucks powder generated by the processing of the layer to be processed by beam irradiation in a range of movement of the irradiation position of the beam irradiated by the beam irradiation unit; and
the powder removing unit is provided with a slit part that makes the stage into a cut-off state in a portion thereof including a range of reciprocation of the beam irradiation position, and a suction unit that sucks the powder from the slit part.

In the invention as set forth in claim 2, the gas ejection mechanism lies below the substrate, so in cases where powder is generated by solidification of the layer to be processed which has been sublimated or liquefied or by exfoliation thereof, due to the beam processing, the powder may be blown away by the ejecting gas, for example. As a result of this, there arises a need to frequently clean the entire working area. However, in this invention, the range of the beam irradiation position of the stage, in which the gas is ejected to support the substrate, is formed as the slit part which is in a cut-off state, and the suction unit for sucking powder is arranged in the slit part, so the powder which is sublimated or liquefied in the beam irradiation position and is then solidified in the vicinity thereof will be immediately sucked.

As a consequence of this, the powder can be collected before being blown away and scattered by the ejecting gas.
Accordingly, even if the beam processing apparatus and the working area are not cleaned frequently, it is possible to keep the beam processing apparatus and its surroundings in a clean state.
In addition, a gas of the layer to be processed which has been generated through sublimation by the irradiation of the beam is also sucked, so it is possible to suppress the thus sublimated layer from solidifying in the vicinity of the substrate and adhering to the substrate.

A beam processing apparatus as set forth in claim 3 is characterized in that in the beam processing apparatus as set forth in claim 1 or 2,
the gas floating mechanism is provided with a stage that has a gas ejection mechanism for ejecting a gas, and supports the substrate by floating it in a flat state, and a moving mechanism that moves the substrate in one direction on the stage;
the beam irradiation unit moves the beam irradiation position in a direction along the direction of movement of the substrate in synchronization with the movement of the substrate at the time of processing the layer to be processed of the substrate, and moves the beam irradiation position in a direction intersecting the direction of movement of the substrate; and
the layer to be processed of the substrate is processed by the beam irradiation by means of the beam irradiation unit in a state where the substrate is moved by means of the moving mechanism.

In the beam processing apparatus as set forth in claim 3, when the layer to be processed of the substrate is processed by the beam, the layer to be processed can be processed by irradiating the beam in a state where the substrate is conveyed, so it is not necessary to repeat the start and stop of conveyance of the substrate at short intervals at the time of processing by beam irradiation. Here, for example, in the case of processing a lot of lines in a stripe shape by repeatedly carrying out linear processing at short intervals, as the substrate is made larger in size and its weight becomes larger, the inertia force thereof also becomes larger, and hence, a large force is required at the time of starting and stopping conveyance, and at the same time, a large load is applied to the moving mechanism (conveyance mechanism). The moving mechanism is required to have a high strength and a large driving force, and the equipment cost and the running cost become high. In addition, there is a possibility that at the start and stop of conveyance, a large load may be applied not only to the moving mechanism but also to the large-sized substrate, so certain measures may be required to be taken so as not to apply an excessively large load to the substrate.

That is, the substrate is conveyed in a floated state, and hence, assuming that the substrate is conveyed at a uniform speed without repeating the start and stop of the conveyance, the moving mechanism does not require a large driving force as well as a large strength, thus making it possible to achieve a reduction in cost. In addition, by processing the layer to be processed while conveying a large-size substrate in a floated state, it is possible to process the substrate while keeping it in a good condition without applying a large load to the substrate.
Moreover, by processing the layer to be processed while conveying it, it is also possible to achieve the shortening of the processing time.
Here, note that as a method of moving the substrate in the direction of processing by the beam while synchronizing the beam irradiation position with the conveyance of the substrate, there are a method of moving a head, which is provided with an objective optical element and irradiates the beam, in a direction synthesized by the direction of conveyance and the direction of processing of the substrate, and a method of scanning the beam along the above-mentioned synthesized direction using a galvanometer mirror.

A beam processing apparatus as set forth in claim 4 resides in a beam processing apparatus in which a beam is irradiated to a layer to be processed which is formed on one surface of a substrate, thereby to process the layer to be processed, and which is characterized by comprising:
a conveyance mechanism that is provided with a support unit for supporting the substrate from below so as to make the substrate in a substantially flat state, and moves the substrate in one direction in a state where the substrate is supported by the support unit;
a beam irradiation unit that irradiates a beam to the layer to be processed which is formed on one surface of the substrate, thereby to process the layer to be processed; and
a powder removing unit that sucks powder generated by the processing of the layer to be processed by the beam irradiation;
wherein the substrate is arranged on the conveyance mechanism with one surface of the substrate on which the layer to be processed is formed being directed upwards, and processing is applied to the layer to be processed by irradiating a beam on the layer to be processed through the substrate by means of the beam irradiation unit from below the other surface of the substrate; and
the powder removing unit sucks and removes, from above the substrate, the powder generated by the processing of the layer to be processed by the beam irradiation.

In the invention as set forth in claim 4, the substrate is arranged in the conveyance mechanism with the layer to be processed being directed upwards, so even if the structure is such that the substrate is supported at its lower side by the support unit, i.e., the support unit is in contact with a lower surface of the substrate, the layer to be processed does not get damaged. Accordingly, by supporting the lower surface side of the substrate with the use of rollers or other like elements as the support unit, it is possible to hold the substrate in a flat state without bending the substrate.
Then, beam irradiation is carried out in a direction from below to above the substrate, so the direction of laser becomes reverse, but the situation becomes the same as the one described above in which beam irradiation is carried out in a direction from above to below the substrate with the layer to be processed being arranged at a lower side.

Accordingly, in this invention, too, the substrate can be prevented from bending by means of the support unit, so the beam irradiation position does not shift up and down to a great extent depending upon the position of the substrate, and even if the irradiation position of the beam moves relatively with respect to the substrate, it becomes possible to include the layer to be processed within a focal range of the beam without changing the focal position thereof. For example, at the start of beam irradiation or at the time of maintenance, etc., by adjusting the focal position of the beam at one time, it becomes unnecessary to change the focal position of the beam at any time during operation.
As a result of this, an auto-focusing mechanism can be omitted, whereby it is possible to reduce the cost of the beam processing apparatus to a substantial extent, and at the same time, it is also possible to simplify the structure of a focusing part of a objective optical device in the beam processing apparatus to a great extent.

In addition, since there is no auto-focusing mechanism, a delay of operation due to the control of an auto-focusing mechanism does not occur, thus making it possible to eliminate a hindrance at the time of achieving the speed up of operation.
Also, processing is carried out with the layer to be processed being directed upwards, so in cases where powder is generated by solidification of the layer to be processed which has been sublimated or liquefied or by exfoliation thereof, due to the beam processing, the powder may adhere again to the layer to be processed on an upper surface side of the substrate. However, in this invention, the powder removing unit sucks and removes, from above the substrate, the powder generated by the processing of the layer to be processed by the beam irradiation, so that the powder (fine particles) can be prevented from adhering again to the layer to be processed.

A beam processing method as set forth in claim 5 resides in a beam processing method in which a beam is irradiated to a layer to be processed which is formed on one surface of a substrate, thereby to process the layer to be processed, and which is characterized by comprising:
processing the layer to be processed by the beam through the substrate by irradiating the beam from above another surface of the substrate opposite to a surface thereof on which the layer to be processed is formed, in a state where the substrate is caused to float in a flat manner with the layer to be processed being directed downwards by means of a gas ejected from below.

In the invention as set forth in claim 5, the same operational effects as those in the invention as set forth in claim 1 can be obtained.

A beam processing method as set forth in claim 6 resides in a beam processing method in which a beam is irradiated to a layer to be processed which is formed on one surface of a substrate, thereby to process the layer to be processed, and which is characterized by comprising:
processing the layer to be processed through the substrate by the beam by irradiating the beam from below another surface of the substrate opposite to a surface thereof on which the layer to be processed is formed, in a state where the substrate is supported from below so as to be substantially flat with the layer to be processed being directed upwards; and
sucking and removing powder generated by the processing of the layer to be processed by the beam from above the substrate.

In the invention as set forth in claim 6, the same operational effects as those in the invention as set forth in claim 4 can be obtained.

A beam processed substrate as set forth in claim 7 is characterized by having a layer to be processed which has been processed by a beam processing apparatus as set forth in any one of claims 1 through 4.

In the invention as set forth in claim 7, the same operational effects as those in the invention as set forth in any one of claims 1 through 4 can be obtained.

### EFFECT OF THE INVENTION

According to a beam processing apparatus, a beam processing method, and a beam processed substrate, a beam for processing the layer to be processed is irradiated from the opposite side of the substrate, so when the layer to be processed of the substrate is arranged at a lower side, bending of the substrate under its own weight can be prevented in a state where the layer to be processed is made out of contact with other members. Because the substrate can be held in a flat or planar manner without making the layer to be processed of the substrate in contact with other members, an auto-focusing mechanism for focusing the irradiation position of the beam corresponding to a bent substrate is not required, as a result of which the beam processing apparatus can be simplified, thus making it possible to achieve a reduction in cost.

### BRIEF DESCRIPTION OF THE DRAWINGS

[Fig. 1] is a plan view showing the outline of a beam processing apparatus according to a first embodiment of the present invention.
[Fig. 2] is a side elevational view showing the outline of the beam processing apparatus.
[Fig. 3] is a plan view showing the outline of a beam processing apparatus according to a second embodiment of the present invention.
[Fig. 4] is a front elevational view showing the outline of the beam processing apparatus according to the second embodiment.
[Fig. 5] is a view for explaining a beam irradiation method of the second embodiment.
[Fig. 6] is a schematic diagram showing a beam processing apparatus according to a third embodiment.
[Fig. 7] is a schematic diagram showing the beam processing apparatus according to the third embodiment.

### BEST MODE FOR CARRYING OUT THE INVENTION

Hereinafter, a first embodiment of the present invention will be described while referring to the attached drawings.

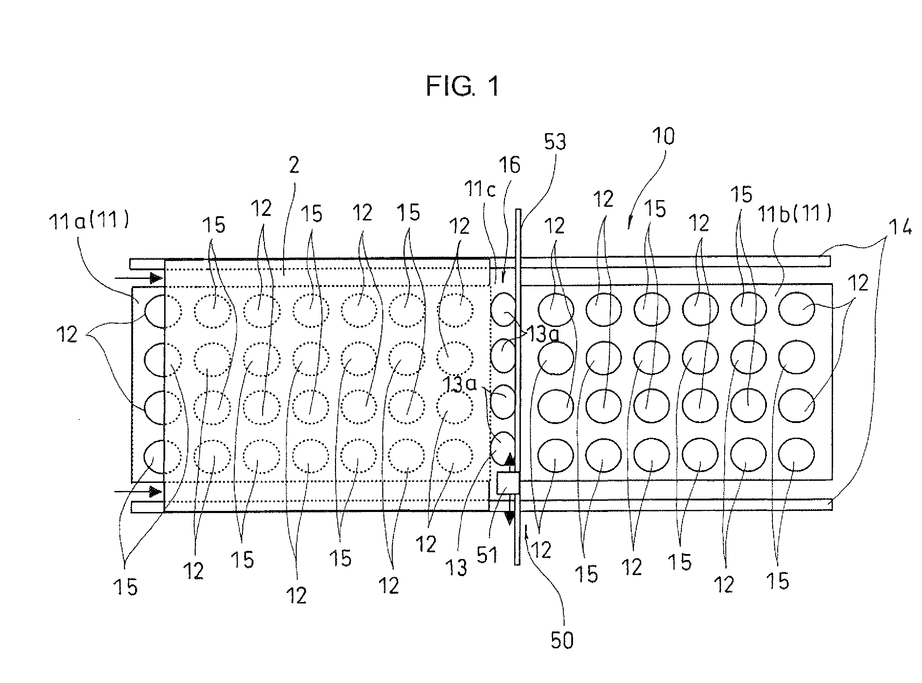

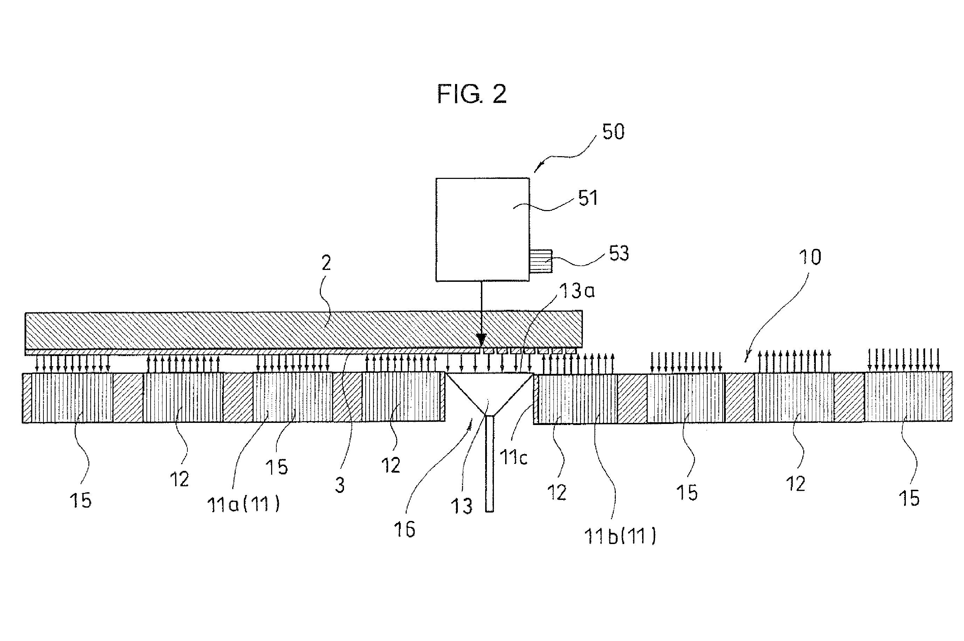

Fig. 1 and Fig. 2 show the schematic construction of a beam processing apparatus according to the first embodiment of the present invention.

The beam processing apparatus of this example is one suitably used, for example, for the production of the above-mentioned power generation systems, plasma displays, etc., and is to pattern a thin film layer formed on a transparent substrate such as a glass substrate, etc., by means of a beam (herein a laser beam), wherein by irradiating a laser beam on the thin film layer (a layer to be processed) on the substrate thereby to sublimate, liquefy and exfoliate it, grooves are formed to make the thin film layer into a divided state, whereby the thin film layer is formed into an arbitrary shape. However, here, grooves are formed in the thin film so as to form a stripe shape or a matrix shape, for example.

This example describes a case in which a final product is assumed to be the above-mentioned power generation system using an amorphous silicon. In the above-mentioned power generation system, a large voltage cannot be obtained, so on a transparent substrate such as a glass substrate, a multitude of cells are formed in a stripe shape, and at the same time are connected in series with one another, thereby making it possible to output a required voltage.

Then, at the time of manufacture, sunlight is first taken in from a glass substrate side, so a thin film of a transparent electrode is formed at the glass substrate side. Then, by forming grooves in the thin film of this transparent electrode at a predetermined interval, the transparent electrode is formed into a stripe shape. Subsequently, on the transparent electrode, there is formed a thin film of amorphous silicone as a semiconductor device which performs photoelectric conversion. Here, note that this portion serves as a semiconductor device having a PN junction or a PIN junction.

Then, an amorphous silicon layer, which comprises a plurality of layers and acts as a photoelectric conversion layer, is deposited on the thin film layer of the transparent electrode patterned into the stripe shape, after which grooves are again formed therein by means of a laser beam. Here, note that these grooves are formed in such a manner that they are arranged adjacent to the above-mentioned grooves formed in the thin film layer of the transparent electrode.

Subsequently, a thin film layer of a metal electrode is formed, and grooves are formed by a laser beam in a similar manner. In this case, the grooves in the metal electrode are formed in such a manner that they are adjacent to the above-mentioned grooves formed in the amorphous silicon layer, and at the same time are adjacent to the grooves in the amorphous silicon layer at a side opposite to the grooves formed in the transparent electrode adjacent to the grooves formed in the amorphous silicon layer. That is, the grooves in the individual layers are formed in a state where they are arranged adjacent to one another in order of the grooves in the transparent electrode layer, the grooves in the amorphous silicon layer, and the grooves in the metal electrode layer.

Then, the beam processing apparatus of the present invention is used for the formation of the grooves to the respective thin films as referred to above.

As shown in Fig. 1 and Fig. 2, the beam processing apparatus is provided with a gas floating mechanism 10 that supports the above-mentioned substrate (the glass substrate 2) in a flatly floated state by ejecting a gas, and a beam irradiation unit 50 that irradiates a beam to a layer 3 to be processed formed on one surface of the above-mentioned substrate thereby to process the layer 3.

The gas floating mechanism 10 is provided, for example, with a stage 11 that is of plate-like shape and is extended long along the direction of conveyance of the glass substrate 2 to be described later, a lot of gas ejection plates 12 that are arranged in such a manner that they are almost uniformly scattered on the stage 11, and a moving mechanism 14 that is arranged at the opposite sides of the stage 11 so that it is in engagement with the opposite side portions of the glass substrate 2 for conveying it along one conveyance direction.

Although the above-mentioned stage 11 is basically of plate-like shape, it may be, for example, of a stripe shaped construction composed of a plurality of plate members which extend along the direction of conveyance. In addition, the stage 11 is in a state in which it is divided, at the location of a linear laser beam irradiation position along the direction of conveyance of an objective optical device 51 to be described later of the beam irradiation unit 50, into two parts, i.e., a rear side (back side) stage rearwardly of, and a front side (forward side) stage forwardly of, the laser beam irradiation position in the direction of conveyance, and a slit part 11c in the form of a slit-shaped space is formed between the rear side stage 11 a and the front side stage 11b.

This slit part 11 c is formed between the stage 11 a and the stage 11 b as a state in which the slit part 11 c divides the stage 11 into the rear side stage 11 a and the front side stage 11 b. Here, note that a slit-shaped opening portion is instead formed at the laser beam irradiation position without dividing the stage 11 into two parts, and this opening portion may also be used as a slit part.

The above-mentioned gas ejection plates 12 are arranged in each part of the stage 11.
In addition, the gas ejection plates 12 are composed of ceramic plates of porous nature, or they are composed of metal plates or resin plates having a large number of holes or pores formed therein.
Then, to the back surface side of each of the gas ejection plates 12 is attached an unillustrated back member of a vessel shape which forms a space in a sealed state where it is dosed except for the side of the corresponding gas ejection plate 12. Piping for supplying a compressed gas is connected to each back member, and a compressed gas supply unit such as for example a compressor, a gas cylinder or the like is connected to this piping so as to supply a compression gas.

The gas ejection mechanism is formed by the gas ejection plates 12, the compressed gas supply unit for supplying the compressed gas to the gas ejection plates 12, the piping connecting between the compressed gas supply unit and the gas ejection plates 12, and so on.
Here, note that, for example, air, a nitrogen gas, or the like is used as the compressed gas, but it is preferable that a gas, which does not affect the layer 3 to be processed, be used. For example, in cases where the layer 3 to be processed is oxidized by oxygen, it is preferable to use an inert gas such as a nitrogen gas.

In addition, in each of the gas ejection plates 12, it may be constructed to have an ejection opening for ejecting a gas, and a suction opening for sucking a gas, or it may be constructed to provide gas suction plates 15 in addition to the gas ejection plates 12.
This is a construction for controlling to keep constant the height of the glass substrate 2 in a floated state by performing ejection of the gas and suction of the gas, and at the same time controlling at least one of the amount of ejection gas and the amount of suction gas.

Even if the gas is only ejected, the float height of the glass substrate 2 can be adjusted to some extent according to the amount of ejection gas, but in order to control the float height of the glass substrate 2 with high accuracy and in a quick manner, for example, in cases where the glass substrate 2 has been moved upwards, it is possible to return the glass substrate 2 downwards in a quick manner, not only by ejecting the gas but also sucking it at the same time, i.e., not by simply decreasing the amount of ejection gas but by sucking the gas in addition to decreasing the amount of ejection gas.

In this case, it is preferable that the gas ejection plates 12 and the gas suction plates 15 are arranged in a distributed manner, for example, in an alternate manner. In addition, it may also be constructed such that the gas suction plates 15 are smaller in number than the gas ejection plates 12. Moreover, it is preferable that the gas suction plates 15 be not arranged in a portion of the glass substrate 2 which becomes in the vicinity of the beam processing position, so as to prevent the gas suction plates 15 from sucking powder generated at the time of beam processing.

Here, note that in the present invention, the slit part 11c which becomes a laser irradiation position is provided with a suction unit 13 to be described later which sucks powder or fine particles produced by laser beam processing, as will be described later, and the height of the glass substrate 2 in the laser irradiation position may be held substantially constant by controlling the amount of suction gas of this suction unit 13 and the amount of ejection gas in the gas ejection plates 12 arranged in the vicinity of the laser irradiation position.

Here, note that in the height adjustment of the glass substrate 2 by the use of the ejection and suction of the gas, for example, the height position of the glass substrate 2 (e.g., the height position of a surface directed to a lower side) is measured in a portion thereof on a straight line which becomes the laser irradiation position or in the vicinity thereof, and the amount of ejection of the gas and the amount of suction of the gas are controlled so as to be adjusted based on the height of the glass substrate 2 as the result of the measurement. Basically, when the height position of the glass substrate 2 has come to tend to rise, the amount of ejection of the gas is decreased and the amount of suction of the gas is increased. On the other hand, when the height position comes to tend to fall, the amount of ejection of the gas is increased, and the amount of suction of the gas is decreased.

Moreover, the moving mechanism 14 is adapted to engage the right and left side edge portions of the glass substrate 2, for example, so that it conveys the glass substrate 2 in the direction of conveyance. Here, note that for a conveyance technique, there can be generally used a mechanism for moving or conveying an object to be processed in one direction, such as for example a ball screw mechanism, a mechanism using a wire, a mechanism using a linear motor, or the like. The glass substrate 2 is made into a state of being floated by means of the gas floating mechanism 10 having the above-mentioned stage 11, so it is not necessary for the moving mechanism 14 to hold the glass substrate 2 in a completely hung state, but it only needs to have a structure that the moving mechanism 14 holds the glass substrate 2 to such an extent that it can push and pull the glass substrate 2 in the direction of conveyance.

The above-mentioned stage 11 is provided with a powder removing unit 16 which draws or sucks powder generated by the processing of the above-mentioned layer 3 to be processed by the beam irradiation of the beam irradiation unit 50 in the range of movement of the beam irradiation position to be described later. In addition, the powder removing unit 16 is provided with the above-mentioned slit part 11 c that is formed in the stage 11, and the suction unit 13 that is arranged in the slit part 11c for sucking or drawing the powder. That is, the slit part 11 c is formed for the purpose of sucking and removing the powder, and serves as a part of the powder removing unit 16.

The suction unit 13 is provided with a plurality of suction openings 13a that are arranged in the slit part 11c, a compressor for performing suction or drawing, piping that connects the compressor and the suction openings 13a with each other, and a cyclone device (illustration omitted) that is arranged in the middle of the piping for performing solid-gas separation (powder separation).
The plurality of suction openings 13a are arranged in row in the above-mentioned slit part 11c in a longitudinal direction of the slit part 11c, i.e., in a direction orthogonal to the direction of conveyance of the glass substrate 2.

Then, the powder drawn or sucked in the suction openings 13a or sublimated gas before becoming powder (i.e., becoming solid during drawing) is drawn or sucked by the compressor to come to the cyclone device.
The cyclone device is a well-known cyclone for powder separation, wherein the solid is centrifuged from the gas by means of a spiral stream of the gas so that substantially only the gas is discharged. This gas then arrives at the compressor.

In addition, the solid collected by the cyclone is reused or discarded.
The beam irradiation unit 50 has a light source device for laser or the like in this example, and is provided with an unillustrated laser generation part which generates laser, and an optical system for irradiating a laser beam on the glass substrate.

The light source device can use, as a laser, at least any one of, for example, a YAG laser, a CO₂ laser, other gas lasers, a solid state laser, a semiconductor laser, a liquid laser, a fiber laser, a thin-film disk laser, and so on.

Here, a YAG laser with a wavelength of 532 nm is used as a laser of visible light, for example.
In addition, the YAG laser basically has a wavelength of 1,064 nm, but there has been known a technique which uses a half of this wavelength, i.e., 532 nm, and by the use of visible light with a wavelength of 532 nm, a laser can penetrate the glass substrate in an efficient manner.

Here, note that the light source is not limited to one for YAG lasers and the wavelength of the laser beam is also not limited to 532 nm, but the laser beam is required to have a wavelength which penetrates a substrate with a layer to be processed such as the glass substrate 2 having the layer 3 to be processed, and for example, in a substrate which visible light penetrates but electromagnetic waves other than the visible light range are difficult to penetrate, it is preferable to use a beam of visible light. In addition, in the layer 3 to be processed, it is preferable for a beam to be absorbed efficiently so that processing can be carried out by means of the beam in an efficient manner, and it is necessary to select the wavelength of an electromagnetic wave used as the beam which is easy to penetrate the substrate (i.e., having a low absorption factor), and which is also easy to be absorbed by the layer 3 to be processed

Moreover, in cases where the substrate is transparent and the layer 3 to be processed is a transparent electrode, there may be selected, for example, visible light of a wavelength which has no peak of absorption at the substrate side, but has a peak of absorption at the transparent electrode side, or a wavelength may be selected which is easy to penetrate the substrate side in a visible light range and in its peripheral regions such as, for example, a near infrared region, and a near ultraviolet legion, but which is difficult to penetrate the side of the layer 3 to be processed.
In addition, the laser beam may be a pulse beam.
Also, the optical system of the beam irradiation unit 50 is provided with an objective optical device (objective lens) 51, wherein a beam is condensed or focused to the layer to be processed, and irradiated to it by means of the objective optical device 51.

The objective optical device 51 is supported, for example, on a guide rail 53, which is arranged over the slit part 11c of the above-mentioned stage 11 and along the slit part 11c (orthogonally with respect to the direction of conveyance of the glass substrate 2) for free movement relative thereto, and hence, the objective optical device 51 is freely movable in a direction perpendicular to the direction of conveyance of the glass substrate 2 in a state guided by the guide rail 53. Also, the objective optical device 51 is reciprocatable along the guide rail 53 by means of a drive device which is not illustrated.

In addition, the supply of the laser beam to the objective optical device 51 is carried out by irradiating a laser beam from the light source device side to the objective optical device 51 by the use of mirrors or prisms, for example, and by turning the direction of irradiation of the beam to the side of the glass substrate 2 and at the same time irradiating the beam to the glass substrate 2 by means of the objective optical device 51. For example, laser is irradiated along the above-mentioned guide rail 53 through the mirrors or prisms from the light source device, so that the laser can always be irradiated to the objective optical device 51 which is moving along the guide rail 53.

Here, note that it may be constructed such that when laser is irradiated to the objective optical device 51, the irradiation of the laser is made by way of an optical fiber.
Also, the objective optical device 51 is adjustable in its focal position according to a known method such as for example changing of the height position thereof, but an automatic focusing function is not provided, and it is not necessary to change the focus of the laser beam in an automatic manner during laser beam processing once the focal position has been adjusted.

Moreover, it may also be constructed such that when an object to be processed is processed into a stripe shape by forming grooves therein due to the irradiation of laser, a plurality of objective optical devices 51 are arranged along the direction of conveyance of the glass substrate 2 so that a plurality of laser beams can be irradiated at one time and at the same time.
That is, the objective optical devices 51 may be arranged side by side in such a manner that laser can be irradiated corresponding to the distances between adjacent ones of the grooves to be formed in the layer 3 to be processed, as a result of which the plurality of grooves can be formed simultaneously by irradiating laser beams at the same time from these objective optical devices, thus making it possible to shorten the operating time.

In this case, too, almost whole of the glass substrate 2 is supported in a substantially planar manner by means of the gas, so it is not necessary to provide an automatic focusing function for each of the objective optical devices 51.
Now, reference will be made to a beam processing method using the beam processing apparatus, as described above.
In this example, the present invention is applied to the production of the above-mentioned power generation system using amorphous silicon as stated above, and beam processing is carried out each time each of a transparent electrode layer, a photoelectric conversion layer and a metal electrode layer is formed on the glass substrate 2.

In beam processing, the glass substrate 2 is conveyed to the beam processing apparatus by the use of a conveyance path which has a gas floating mechanism 10 similar to the above-mentioned gas floating mechanism 10. In this case, the layer 3 to be processed which is processed by the laser beam is located below the glass substrate 2. That is, the glass substrate 2 is made into a state of being floated slightly on the stage 11 of the gas floating mechanism 10 with a surface having the layer to be processed which is formed thereon being arranged at a lower side. Then, in the beam processing apparatus, the glass substrate 2 is connected with the moving mechanism 14 on the stage 11 of the gas floating mechanism 10, and is conveyed in the direction of conveyance orthogonal with respect to the direction of movement of the objective optical device 51.

Thereafter, the conveyance is stopped at the time when an end of the glass substrate 2 which is a leading side in the direction of conveyance thereof arrives at the above-mentioned slit part 11c of the stage 11, and hence when a groove forming position of the layer 3 to be processed which is formed on the glass substrate 2 has arrived at the objective optical device 51 supported by the guide rail 53.
Then, grooves are formed by moving the objective optical device 51 in one direction along the guide rail 53 from one side edge of the layer 3 to be processed to the other side edge thereof in a state where laser is being outputted, so that the layer 3 to be processed is divided by the grooves thus formed.

In addition, in this case, the suction unit 13 of the powder removing unit 16 is driven to operate, so that it sucks, from the slit part 11c arranged under the range of movement of the objective optical device 51, the gas at the side of the layer 3 to be processed of the glass substrate 2 arranged over the slit part 11c. As a result of this, powder of the substances constituting the layer to be processed, which has been generated by being sublimated or liquefied due to the irradiation of the laser beam and then solidified, and powder generated by the exfoliation of these substances due to the irradiation of the laser beam, are sucked by the suction unit 13.

By doing so, even if powder is generated by laser beam processing, the powder is prevented from being scattered by an ejecting gas to contaminate the beam processing apparatus and its surroundings, as a consequence of which the beam processing apparatus and its surroundings can be held in a clean state.
In addition, it becomes possible to suck from the slit part 11c of the stage 11 the gas and powder of the layer 3 to be processed, which have been generated in the layer 3 to be processed of the glass substrate 2 directed to the side of the slit part 11c, in a state where the stage 11 and the glass substrate 2 are separated from each other by a slight distance, in other words, in a state where the stage 11 and the glass substrate 2 is close to each other, so these gas and powder can be sucked in an efficient manner. That is, the powder can be removed in a reliable manner.

Subsequently, the glass substrate 2 is again conveyed by means of the moving mechanism up to a position in which the next groove forming position of the layer 3 to be processed comes to the laser beam irradiation position.
Then, while outputting a laser beam, the objective optical device 51 is driven to move along the guide rail 53 in a direction opposite to the direction of movement thereof at the time of an immediately preceding laser irradiation, so that grooves are formed in the layer 3 to be processed.
By repeating the above operations until grooves have been formed in all the portions of the layer 3 to be processed which should be subjected to groove processing, all the grooves are formed with respect to the one layer 3 to be processed. Subsequently, after the following layer 3 to be processed is formed on the existing layer 3 to be processed, the above-mentioned beam processing is carried out again.

Then, a transparent electrode layer, a photoelectric conversion layer (amorphous silicon layer), and a metal electrode layer are formed as described above, and at the same time, grooves are formed in all these layers by means of beam processing. As a result, on the glass substrate 2, there is produced the above-mentioned power generation system which is divided into a lot of cells which are joined in series to one another.
In this case, the glass substrate 2 is in the state of being floated by means of the ejecting gas in such a manner that the glass substrate 2 may not bend. Therefore, it is not necessary to perform the adjustment of focus during beam processing by means of an auto-focusing mechanism in order to cope with the bending under its own weight of the glass substrate 2 as described above, and hence there is no need to provide an auto-focusing mechanism, thus making it possible to achieve a reduction in the cost of the beam processing apparatus.

Further, due to provision of no auto-focusing mechanism, control for auto-focusing does not become a bottleneck for the speed of beam processing, and the delay factors of beam processing are decreased, thus making it possible to achieve a further improvement in the speed of beam processing.
Also, the slit part 11c corresponding to the range of movement of the irradiation position of the laser beam (the moving range of the objective optical device) is formed in the stage 11, and in this slit part 11 c, the layer to be processed which is being sublimated or liquefied by the irradiation of the beam at a location right above the slit part 11 c is sucked as gas or powder, so that the powder generated by beam processing can be collected without being scattered, thus making it possible to keep the beam processing apparatus and its surroundings in a clean state.

In addition, gas streams will be generated from the gas ejected from the stage 11, and the gas sucked in the slit part 11 c, so that it will be possible to suppress part of the layer 3 to be processed sublimated or liquefied at the beam irradiation position of the glass substrate 2 from solidifying again at the beam irradiation position and readhering to the grooves thus formed.
As a result of this, it becomes possible to carry out beam processing with a higher degree of precision, and if the above-mentioned power generation system uses, based thereon, amorphous silicon as the layer 3 to be processed, it will be possible to increase the power generation efficiency of the power generation system.

Moreover, in cases where beam processing is also intended to be speeded up by irradiating a plurality of beams at the same time by the use of the plurality of the objective optical devices 51 thereby to form a plurality of grooves in the layer to be processed simultaneously, because the glass substrate 2 is supported by the ejecting gas so as not to bend or sag, there is only a low possibility that the individual focal positions of the plurality of beams will get out of the layer 3 to be processed, and it becomes possible to adjust the focal positions of the beams with a higher degree of accuracy, so by carrying out a plurality of beam processing operations at the same time, variation in processing accuracy which may occur can be suppressed, and beam processing can be performed with a higher degree of accuracy. Also, according to such beam processing of high accuracy, it is possible to attain an improvement in the power generation efficiency of the above-mentioned power generation system. That is, it is known that if the accuracy of beam processing reduces, the power generation efficiency of the above-mentioned power generation system produced will fall, so the decrease of the power generation efficiency can be prevented due to the improvement in the accuracy of beam processing, thereby making it possible to produce the above-mentioned power generation system of higher power generation efficiency.

Further, even if the beam processed substrate having the layer 3 to be processed which has been processed by means of the beam processing apparatus of the present invention is produced with substantially the same conditions as those for a conventional beam processing apparatus without the gas floating mechanism 10, it is possible to achieve an improvement in processing accuracy, and hence, it is possible to expect an improvement in performance based thereon.

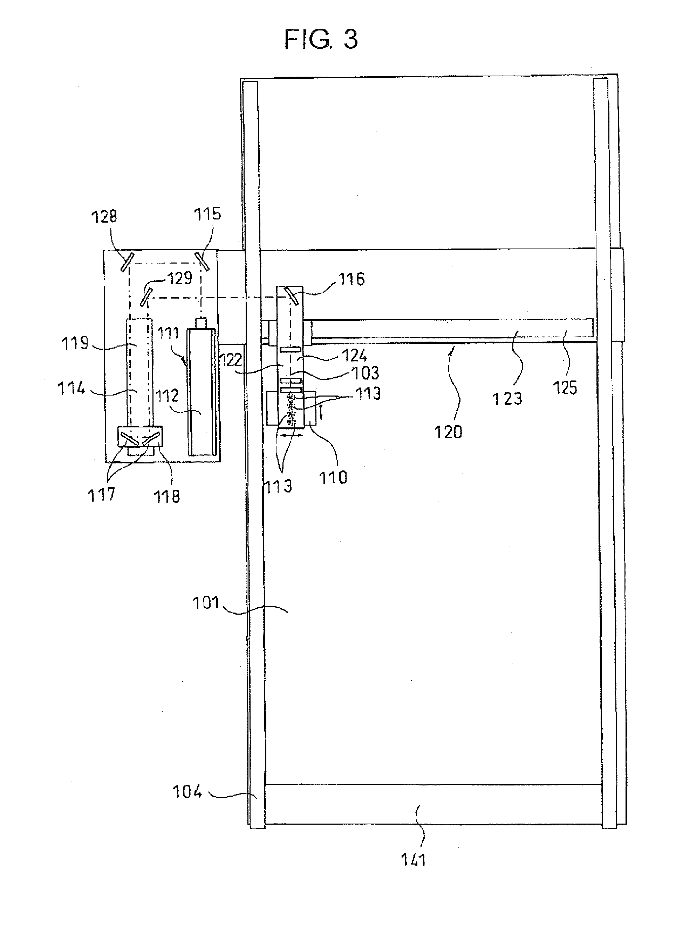

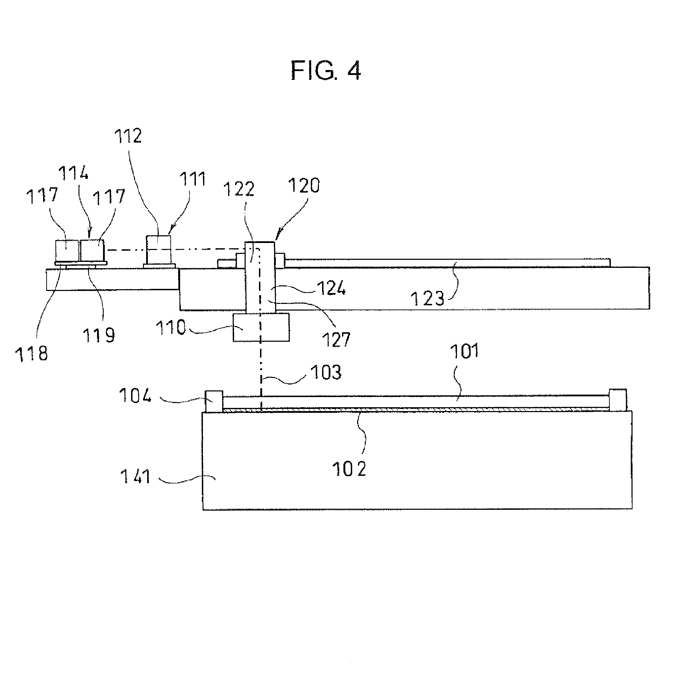

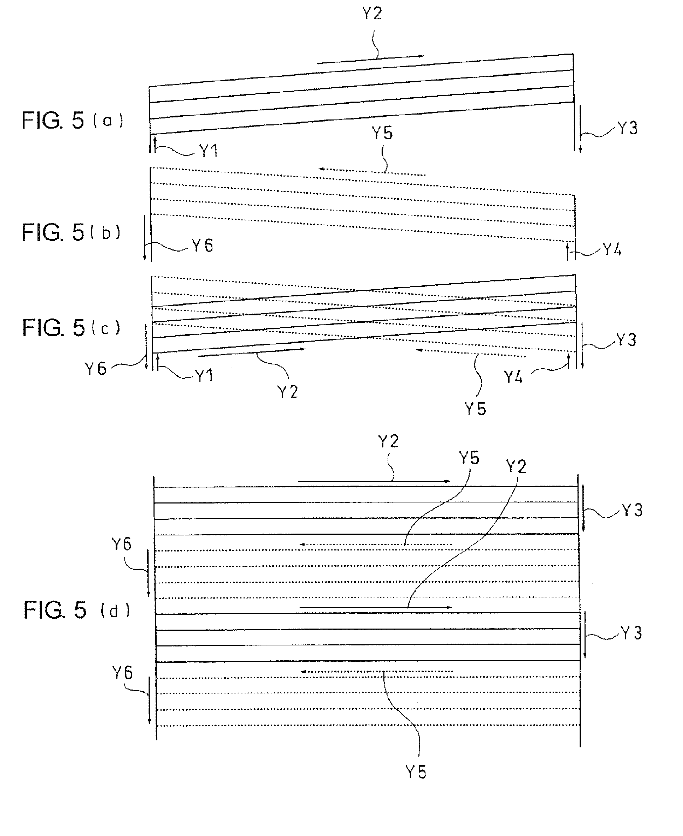

Fig. 3 and Fig. 4 show the schematic construction of a beam processing apparatus according to a second embodiment of the present invention. Also, Fig. 5 shows a view for explaining the movement of a head which irradiates a beam.
In the first embodiment of the present invention, beam processing is carried out in a state where the conveyance of the glass substrate 2 is stopped, but in contrast to this, in the second embodiment, beam processing is performed in a state where a substrate 101 which is similar to the glass substrate 2 is being conveyed without being stopped, and this second embodiment is different from the first embodiment in a mechanism for moving the irradiation position of a beam in a beam irradiation unit, but the construction other than that is substantially the same as that in the first embodiment, and explanation about the same components will be simplified.

The beam processing apparatus of the second embodiment can be used for the same purpose as the first embodiment of the present invention, and is able to carry out similar processing. This beam processing apparatus can produce a power generation system which makes use of a photoelectric effect, as in the first embodiment of the present invention.

As shown in Fig. 3 and Fig. 4, the beam processing apparatus is provided with: a conveyance mechanism (moving mechanism) 104 that conveys the substrate 101 in one direction for the purpose of machining or processing a layer 102 to be processed (thin film layer) formed on one surface of the substrate 101 by the irradiation of a beam 103 thereon; a beam irradiation device 111 (beam irradiation unit) that irradiates the beam 103 to the layer 102 to be processed which is formed in one side surface of the substrate 101 from the other side surface of the above-mentioned substrate 101 which is conveyed by means of the conveyance mechanism 104 while penetrating the substrate 101, and at the same time has a head 110 for irradiating the beam onto the substrate 101 perpendicular with respect thereto upon beam irradiation; and a head moving device 120 that is able to move the above-mentioned head 110 simultaneously in two directions mutually intersecting each other along a surface parallel to the substrate 101 conveyed by the above-mentioned conveyance mechanism 104

The substrate 101 and the layer 102 to be processed of the substrate 101 in this example are the same as those of the first embodiment, for example. Also, the conveyance mechanism 104 is the same as the moving mechanism 14 of the gas floating mechanism 10 in the first embodiment. In addition, in this second embodiment, too, a gas floating mechanism 10 is used, and a stage 141 which is the same as the stage 11 of the first embodiment is used and serves to float the substrate 101 by ejecting a gas.
Here, note that the direction of conveyance of the substrate by the conveyance mechanism 104 is a direction orthogonal to the direction of grooves in the layer 102 to be processed which are formed by being processed into a stripe shape on the substrate 101.
That is, it is necessary to set the substrate 101 on the conveyance mechanism 104 in such a manner that the substrate 101 is conveyed in a direction orthogonal to the direction of the grooves to be formed.

Then, the beam irradiation device 111 having the head 110 is provided with a light source device 112 that generates laser, and a beam guiding system that serves to guide the laser from the light source device 112 to the head 110.
The light source device 112 outputs the same laser as in the first embodiment, for example.

Here, note that in this example, the head 110 serves to irradiate the layer 102 to be processed with a plurality of laser beams at the same time, and a plurality of objective optical devices 113, e.g., four objective optical devices 113 here, are arranged. Here, note that four beams are outputted in the light source device 112, too, corresponding to the number of beams being irradiated.
In addition, the beam guiding system to guide the laser from the light source device 112 to the head 110 is composed of a plurality of mirrors 115, 116, 117, 128 and 129, in this example.

Moreover, the beam guiding system of the beam irradiation device 111 is provided with an optical path length adjusting device 114 that serves to hold the optical path length of the head 110 from the light source device 112 substantially uniform irrespective of the moved position of the head 110.
In this example, the head 110 is designed to move a distance substantially equal to about the width of the substrate 101 along an X axis direction as a widthwise direction of the substrate 101 orthogonal to a Y axis direction as the direction of conveyance of the substrate 101, and in cases where the substrate 101 is a glass substrate of a large size, the distance from the light source device 112 to the head 110 changes to a large extent in accordance with the movement of the head 110.

Here, the laser beam outputted from the light source device 112 is converted to a parallel beam by means of a collimating lens, for example, however it does not become a perfect parallel beam, but is slightly diffused due to diffraction, etc., so that the diameter of the beam becomes gradually larger. Accordingly, if it is constructed such that the head 110 is moved away from or toward the light source device 112 to a large extent at the time of guiding the laser beam to the head 110 by the use of the mirrors, there will occur a clear difference in the beam diameter of the laser beam which is incident to the objective optical device 113, depending upon whether they are moved away from or toward each other, as a result of which there will be, for example, a change in the focal position, or a change in the beam strength, thus resulting in an impediment to precise processing.

Accordingly, in this example, the laser beam is guided while being detoured to the optical path length adjusting device 114.

Here, note that the above-mentioned beam guiding system need be basically provided with the first mirror 115 that serves to guide the laser beam outputted from the light source device 112 in the X axis direction, and the second mirror 116 that is mounted on an X axis sliding block 122 to be described later as a part which moves in the X axis direction integrally with the head 110 and which does not move in the Y axis direction, and further serves to guide the laser beam from the first mirror 115 to the head 110 while bending it at an angle of 90 degrees so as to advance it along the Y axis direction. In this example, however, the optical path length adjusting device 114 is arranged in the optical path of the laser beam between the first mirror 115 and the second mirror 116.

Here, note that in this example, the optical path length adjusting device 114 is arranged adjacent to the light source device 112, which has its optical axis disposed along the Y axis direction, so as to adjust the optical path length with respect to the movement in the X axis direction of the head 110, but the direction of a laser beam incident to the optical path length adjusting device 114, and the direction of a laser beam emitted from the optical path length adjusting device 114 are made to be the Y axis direction instead of the X axis direction. In addition, the optical path length adjusting device 114 is arranged at a location which is not between the first mirror 115 and the second mirror 116 but is outside of these mirrors and at the side of the first mirror 115. Accordingly, it is designed such that the first mirror 115 reflects a laser beam going from the first mirror 115 to the second mirror 116 along the X axis direction, not to the side of the second mirror 116 but toward the opposite side thereof.
Also, provision is further made for the third mirror 128 that serves to make the laser beam reflected from the first mirror 115 incident to the optical path length adjusting device 114 by bending it at an angle of 90 degrees from the X axis direction to the Y axis direction, and the fourth mirror 129 that serves to bend the laser beam along the Y axis direction emitted from the optical path length adjusting device 114 toward the X axis direction and at the same time to reflect it to the second mirror 116.

In addition, in the optical path length adjusting device 114, there are arranged the mirrors 117,117 for reflecting and outputting a laser beam in a direction parallel to the direction of a laser beam which has been guided to enter the optical path length adjusting device 114. The mirrors 117, 117 are arranged two, for example, i.e., one mirror 117 serves to reflect an incident laser beam by bending it an angle of 90 degrees, and the other one serves to further bend the thus bent laser beam at an angle of 90 degrees, whereby the laser beam is bent at an angle of 180 degrees in total together with the bent angle of the above-mentioned one mirror 117. As a result, the incident laser beam can be reflected and returned in a direction parallel to the incident laser beam. Here, note that there is a deviation between the position of the incident laser beam and the position of the emitted laser beam which is reflected in parallel to this, wherein the incident laser beam has been reflected by the first mirror 115 and the third mirror 128 at the side of the light source device 112 in this order, and the emitted laser beam goes to the second mirror 116 of the X axis sliding block 122 which supports the head 110 through the fourth mirror 129.

Here, the two mirrors reflecting the laser beam in the optical path length adjusting device 114 are arranged to be movable in the optical path length adjusting device 114 along the optical axes of the incident laser beam and the emitting laser beam which are mutually parallel to each other, along the directions parallel to these laser beams, i.e., the directions of the optical axes thereof.

That is, the optical path length adjusting device 114 is provided with a sliding block part 118 on which the above-mentioned two mirrors 117, 117 are carried, a rail part 119 which guides the sliding block part 118 so as to be freely movable in the above-mentioned optical axis direction (Y axis direction), and an unillustrated driving source which drives the above-mentioned sliding block part 118 to move along the rail part 119. Here, note that the driving source may be anything that can drive the sliding block part 118 to reciprocate in a rectilinear direction, for example, such as a rotary motor, a linear motor, etc., which has a driving mechanism, such as a belt, a wire, a ball screw, etc., which can convert a rotary motion into a rectilinear motion.

Then, the beam guiding system having this optical path length adjusting device 114 is provided with the first mirror 115 and the third mirror 128 which serve to guide the laser beam outputted from the light source device 112 in the X axis direction and at the same time turn the laser beam to one mirror 117 of the above-mentioned two mirrors 117, 117 of the optical path length adjusting device 114, and the second mirror 116 and the fourth mirror 129 which serve to turn the laser beam outputted from the optical path length adjusting device 114 to the objective optical device 113. Here, note that if the laser beam incident to the optical path length adjusting device 114 and the laser beam emitted from the optical path length adjusting device 114 are along the X axis direction, it is not necessary to use the third mirror 128 and the fourth mirror 129 which convert a laser beam between the Y axis direction and the X axis direction for the optical path length adjusting device 114. In addition, retroreflective prisms such as corner cubes, retroreflectors, etc., may be used instead of the mirrors 117, 117.

In addition, actually, the light reflected by the second mirror 116 is made incident to the objective lens of the objective optical device 113 by being reflected in the Z axis direction, for example, by an unillustrated mirror which is arranged in the above-mentioned objective optical device 113.
Also, in Fig. 3, the optical path of one laser alone is shown, but here, a plurality of, for example, four laser beams, being arranged at intervals in the Z axis direction, are guided from the light source device 112 to objective optical devices 113 through similar optical paths, respectively, wherein they are changed into the X axis direction by means of the four objective optical devices 113, respectively. Here, note that it is constructed such that a laser beam at the lowest position in the Z axis direction (in the height direction) among the beams reflected by the second mirror 116 is made incident to an objective optical device 113 which is nearest to the second mirror 110, and laser beams in order higher therefrom are made incident to objective optical devices 113 which become farther from the second mirror 116, respectively.

Moreover, the head moving device 120 has an X axis moving mechanism 123 that enables the movement of the head 110 over a range slightly wider than the width of the layer 102 to be processed of the substrate 101 along the X axis direction which becomes the direction of groove processing, and a Y axis moving mechanism 124 that is mounted on the X axis sliding block 122 mounted on the X axis moving mechanism 123 for making the head 110 movable along the Y axis direction.

In this example, the X axis moving mechanism 123 and the Y axis moving mechanism 124 are each composed of a linear motor, and the movement of the head 110 can be controlled in a precise manner by using a linear servo motor or a linear stepping motor, for example.
Then, the X axis moving mechanism 123 has an X axis guide part 125 that has a stator of a linear motor extending along the X axis direction, and the X axis sliding block 122 that has a moving element movable along the stator.

The X axis guide part 125 guides the X axis sliding block 122 in the X axis direction, and at the same time the stator drives the moving element in the X axis direction.

Also, the Y axis moving mechanism 124 mounted on the X axis sliding block 122 has a guide part 127 that has a stator of a linear motor extending along the Y axis direction, and the head 110 that has a moving element movable along the stator.

According to the above construction, the head 110 is movable in the X axis direction within the range including the width of the layer 102 to be processed which is formed on the substrate 101. In addition, the movable distance in the Y axis direction of the head 110 is about a distance which is equal to the interval between adjacent grooves multiplied by the number of beam emitting parts (the objective optical devices 113) in cases where the interval of the beam emitting parts in the head 110 is made equal to the interval of the grooves formed in the layer 102 to be processed of the substrate 101.

For example, in cases where four grooves are formed by means of four beams at the same time, it is necessary to end the movement of the head 110 along the X axis direction of the layer to be processed, and to complete the processing of four grooves before the substrate 101 has been conveyed in the Y axis direction a distance equal to the interval of the grooves multiplied by 4 as the number of the beams simultaneously irradiated.
Accordingly, basically, the moving distance in the Y axis direction of the head 110 more than the length which is equal to the interval of the grooves to be processed multiplied by the number of beams emitted from the head 110, as described above, is not required.

Here, note that, as will be described later, the speed of movement in the Y axis direction of the head 110 and the speed of movement in the Y axis direction of the substrate 101 are controlled so as to be equal to each other, but in contrast to the substrate 101 which performs a continuous movement, the head 110 returns in a reverse direction, stops, and again starts to move in the Y axis direction (in the forward direction) each time a groove forming operation is carried out, so the distance of acceleration for accelerating the speed of movement in the Y axis direction of the head 110 to the speed of movement of the substrate 101 is required.

If the substrate 101 advances by the interval between the adjacent grooves from the grooves produced by one groove producing operation of the head 110, the next production of grooves by the head 110 will become unable to be made, so the moving distance in the Y axis direction of the head 110 is sufficient if it is equal to the above-mentioned distance at the maximum.

Accordingly, the moving distance in the Y axis direction of the head 110 by the Y axis moving mechanism 124 is designed to be extremely short as compared with the size of the substrate 101.
Then, reference will be made to a beam processing method accompanying the movement of the head 110 by the head moving device 120 which has the X axis moving mechanism 123 and the Y axis moving mechanism 124.
Here, note that the movement control of the head is carried out by an unillustrated movement control device (a movement control unit).

The movement control device is to control the X axis moving mechanism 123 and the Y axis moving mechanism 124 which are composed of linear motors, and basically, control will be carried out as well-known servo motor control or stepping motor control.
In the beam processing method, first of all, it is assumed that the substrate 101 is driven to move at a predetermined speed SK by means of the conveyance mechanism 104. In addition, a beam irradiation starting position will be set to the substrate 101 for each of the number of grooves corresponding to the number of irradiations of a beam in the head 110. Here, note that beam irradiation starting positions will be set to the left side edge and the right side edge of the layer 102 to be processed in an alternate manner.
Then, at the time when the beam irradiation starting position becomes, for example, a beam irradiation position of that beam irradiation part of the head 110 which is at the most rear side in the direction of conveyance of the substrate 101 among beam irradiation parts of the head 110, the irradiation of a laser beam in the head 110 will be started. Here, note that the laser beam may also be irradiated only when the layer 102 to be processed is processed, and may be put in a state where irradiation is stopped when the head 110 is moving except for the purpose of processing, but the laser beam may instead remain outputted even in a state where the layer 102 to be processed is not being processed, so that the laser beam is made into a stable state.

In this case, the speed of movement of the head 110 along the Y axis direction and the speed of movement of the substrate 101 along the Y axis direction are required to be the same so that they are in synchronization with each other.
Accordingly, in the movement control, first, the head 110 is at the left side of the substrate 101 which is moving in the direction of conveyance, for example, and a beam irradiation starting position of the substrate 101 being conveyed which is to be next irradiated with a beam is located at the left side thereof. In addition, it is also assumed that the head 110 is located at an origin position in the Y axis direction, i.e., basically at the most rear side in the direction of conveyance. Further, it is also assumed that the head 110 is located at an origin position either at the right side or at the left side in the X axis direction. Here, note that with respect to the X axis direction, there are an origin position which is at the most left side and an origin position which is the most right side, in the movement of the head 110.

In addition, the origin position need not be the endmost position of a structural movable range of the head 110, but may be at the endmost potion in the range of movement at the time of groove processing. In this case, it is assumed that the structural movable range of the head 110 is larger than the range of movement in which the head 110 moves at the time of groove processing.
Then, the movement in the Y axis direction of the head 110 is started at the time when the above-mentioned beam irradiation starting position of the substrate 101 comes to a location at a predetermined distance before the beam irradiation position of a beam emitting part which is at the most rear side of the head 110 in the direction of conveyance. The speed of movement of the head 110 is accelerated until it becomes equal to the speed of conveyance of the substrate 101, and is then made constant at that time and thereafter.
Also, when this speed has become constant, the above-mentioned beam irradiation starting position of the substrate 101 and the above-mentioned beam irradiation position of the head 110 are required to be equal to each other.

Then, as shown in Fig. 5(a), the beam irradiation position from the head 110 moves in the Y axis direction along an arrow Y1 in an accelerated manner. At the time when the speed of movement of the head 110 becomes equal to the speed of conveyance of the substrate 101 and at the same time when the beam irradiation starting position and the beam irradiation position become equal, the irradiation of beams is started, and at the same time, the head 110 is driven to move along the X axis direction. As a result of this, the irradiation positions of four beams irradiated from the head 110 are caused to move diagonally forward right along an arrow Y2, as shown in Fig. 5(a). Here, note that a period of acceleration is needed for movement in the X axis direction, too, so in actuality, it is necessary to start the movement in the X axis direction of the head 110 before the above-mentioned beam irradiation starting position and the above-mentioned beam irradiation position become equal.

Although the movement in the X axis direction of the head 110 in this case is basically a uniform movement, acceleration is required at the beginning, and deceleration or slowing down is required at the end, as described above. In particular, in cases where the processing by laser beams is influenced by a difference in speed due to acceleration or deceleration, the start position and the stop position of the X axis movement of the head 110 are made to be outside of the right and left side edges of the layer 102 to be processed, and the head 110 is started to move while being accelerated in the X axis direction at the start position of the axis movement thereof. At the time when the head 110 has arrived at a side edge of the layer 102 to be processed from the outside thereof, the speed of movement in the X axis direction of the head 110 is made to be a predetermined speed SX, after which the head 110 is driven to move uniformly at a predetermined speed during the time when the beams are irradiated on the layer 102 to be processed.
Here, note that the acceleration in the Y axis direction is performed simultaneously at the time of acceleration in the X axis direction in the outside of the layer 102 to be processed.

Here, the step in which the head 110 is accelerated in the Y axis direction and in the X axis direction is a one side edge acceleration step (a left side edge acceleration step.
Then, the step at which the head 110 performs a uniform movement in the Y axis direction at the speed of conveyance SK of the substrate 101 and at the same time performs a uniform movement in the X axis direction at the predetermined speed SX, as described above, is a forward direction uniform speed processing step.
Then, at the time when the irradiation positions of the laser beams have arrived at the opposite side edge of the layer 102 to be processed, the speed of the movement in the X axis direction of the head 110 can be decelerated or slowed down and stopped.

Then, at the time when the uniform movement in the X axis direction has ended, i.e., at the time when the uniform movement in the Y axis direction has also ended, the head 110 is driven to move in the Y axis direction in a reverse direction opposite to the direction of conveyance of the substrate 101. In this case, in the movement in the Y axis direction, the head 110 is slowed down and stopped, and then is driven to move in the reverse direction. At this time, the movement in the X axis direction is also slowed down and stopped. This step of returning the head 110 to the origin position is an other side edge origin returning step.
In addition, at this time, a next beam irradiation starting position in the substrate 101, which follows the current beam irradiation starting position in which the irradiation of the laser beams has been carried out as stated above, moves at the above-mentioned predetermined speed of conveyance SK.

On the other hand, the head 110 is driven to move in the reverse direction opposite to the direction of conveyance along the Y axis direction, so that it is returned to the origin position. In the X axis direction, there are two origin positions in the right and left, and the head 110 is put into a stopped state at the right origin position which is opposite to the left origin position.
At this time, the head 110 is returned to the above-mentioned origin position in the Y axis direction along the Y axis direction, as shown by an arrow Y3 in Fig. 5(a), but in this case, the next beam irradiation starting position of the substrate 101 need still be at a rear side from the above-mentioned current beam irradiation position of the head 110, and it is required that when the head 110 starts moving and becomes a predetermined speed, the next beam irradiation starting position of the substrate 101 has caught up with the above-mentioned beam irradiation position of the head 110, as described above.

Here, note that if neither acceleration nor deceleration is taken into consideration, in this state, the next beam irradiation starting position of the substrate 101 will be adjusted or aligned to the beam irradiation position of the head 110, but in actuality, the next beam irradiation starting position is adjusted to the beam irradiation position of the head 110 through an other side edge acceleration step in which the head 110 is again started to move along the X axis direction and the Y axis direction and at the same time is accelerated. Thus, these other side edge origin returning step and other side edge side acceleration step are combined to constitute an other side edge irradiation position alignment step. Here, note that in the other side edge acceleration step, the same processing as that in the above-mentioned one side edge acceleration step is basically carried out except for that the left and right positions are reversed.
That is, the head 110 is accelerated in the Y axis direction, as shown by an arrow Y4 in Fig. 5(b).

In addition, in the X axis direction, too, the head 110 is accelerated in a similar manner except for that it is moved from the right to the left, oppositely to the above-mentioned case, from the right side origin position to the left side origin position at which the above-mentioned movement in the X axis direction starts.
Then, in the other side edge acceleration step, at the time when the speed of movement in the Y axis direction becomes the above-mentioned speed of conveyance SK of the substrate 101, and when the speed of movement in the X axis direction also reaches the predetermined speed, and when the beam irradiation starting position of the substrate 101 comes to the irradiation starting position of the head 110, processing by laser beams is carried out, as a reverse direction uniform speed processing step, by driving the head 110 to move at uniform speed in the X axis direction in the reverse direction opposite to the forward direction in the case of the forward direction uniform speed processing step, as well as to move at uniform speed in the Y axis direction. That is, the head 110 moves in a direction of an arrow Y5 in Fig. 5(b).

Then, similar to the above-mentioned case, after uniform movements of the head 110 in the X axis direction and in the Y axis direction are completed and the head 110 is slowed down and stopped in the X axis direction and is also slowed down and stopped in the Y axis direction, a one side edge origin returning step to return the head 110 to the origin position along the Y axis direction is carried out, as shown by an arrow Y6.
Then, after the head 110 is made to return in the Y axis direction in the reverse direction opposite to the direction of conveyance to the origin position, a return is made to the first step.
Thus, the one side edge origin returning step and the first one side edge acceleration step together constitute a one side edge irradiation position alignment step to adjust or align the beam irradiation position of the head 110 to a beam irradiation starting position of the substrate 101.

In the above beam processing method, the movement of the head 110 is a bow tie-like movement, as schematically illustrated in a schematic diagram of Fig. 5(c). That is, the head 110 moves diagonally from the left side to the forward right side, then returns straight to the rear side, moves diagonally from the right side to the forward left side, and thereafter returns straight to the rear side, whereby the shape of movement thereof becomes a bow tie-like shape.
In addition, in such a movement, the speed of the head 110 in a forward movement, i.e., in a movement in the Y axis direction, in a movement from the left side to the forward right side matches the speed of conveyance of the substrate 101, and the speed of the head 110 in a forward movement, i.e., in a movement in the Y axis direction, in a movement from the right side to the forward left side matches the speed of conveyance of the substrate 101, as a result of which the processed shape in the layer 102 to be processed of the substrate 101 becomes such that grooves are arranged side by side at equal intervals in a stripe shape.
Here, note that in Fig. 5(a) through Fig. 5(d), solid lines indicate processing in the forward direction (here, from the left to the right), and broken lines indicate processing in the reverse direction (here, from the right to the left).

In the movement control of the head 110 for carrying out such a beam processing method, processing in the Y axis direction and processing in the X axis direction are simultaneously performed by the above-mentioned movement control device, and control will be carried out in outline steps which will be shown below.
The position of the head 110 is made to be the Y axis origin position and the X axis left side origin position (may also be the right side origin position). Here, note that in servo control, sensors for measuring the positions of the moving elements, respectively, are arranged at the stator side in the X axis moving mechanism 123 and the Y axis moving mechanism 124, respectively, so that the position of the head can be measured by measuring the positions of the moving elements by means of the sensors in the Y axis moving mechanism 124 and the X axis moving mechanism 123, respectively.

The head 110 will be moved if it does not exist at a predetermined head position. In addition, during the operation of the head 110, too, feedback control is carried out according to the positions obtained by the above-mentioned sensors.
The conveyance mechanisms 104 operate in association with each other, so that the conveyance of the substrate 101 is carried out, and the substrate 101 is accelerated up to the predetermined speed SK and is conveyed at the predetermined speed SK.

Then, when the above-mentioned beam irradiation starting position of the layer to be processed of the substrate 101 arrives at a predetermined position, that is, when it comes to a position which lies a predetermined distance L1 from the beam irradiation starting position with respect to the beam starting position of the head 110 which exists at the origin position, the following processing is carried out.
That is, in the Y axis moving mechanism 124, the moving element is accelerated from a speed of 0 to a predetermined speed SK, and the acceleration at this time is set to an acceleration by which the moving element reaches the predetermined speed SK in a predetermined period of time in which it moves the predetermined distance.

Here, the predetermined speed SK is the same speed as the speed of conveyance SK in the conveyance mechanism 104. At this time, the substrate 101 moves by a distance over which the substrate 101 is conveyed at the predetermined speed SK in the above-mentioned predetermined period in addition to the above-mentioned predetermined distance, and in this case, the above-mentioned beam starting position is set to be the beam irradiation position of the head.
In addition, in the X axis moving mechanism 123, the moving element is accelerated from a speed of 0 to a predetermined speed SX. At this time, the beam irradiation position of the head 110 arrives at the above-mentioned beam irradiation starting position at one side edge of the layer 102 to be processed from the outside of the layer 102 to be processed.

In this state, the speed of the moving element of the Y axis moving mechanism 124 becomes the predetermined speed SK, and the speed of the moving element of the X axis moving mechanism 123 becomes the predetermined speed SX. At the same time, the position of the head 110 becomes such that the beam irradiation position thereof comes to the beam irradiation starting position of the substrate 101. This control step constitutes a one side edge acceleration control step.
In this state, the moving element of the X axis moving mechanism 123 and the moving element of the Y axis moving mechanism 124 continue to move while remaining in the above-mentioned state until the beam irradiation position of the head 110 comes to a processing end position at the other side edge of the layer 102 to be processed. This constitutes a forward direction uniform speed processing control step.
Then, when the processing end position is reached, the moving element in the Y axis moving mechanism 124 is decelerated or slowed down rapidly, and stopped, then is moved with rapid acceleration in the reverse direction, returning to the Y axis origin position, wherein in the vicinity of the Y axis origin position, the moving element is again slowed down rapidly and is stopped at the Y axis origin position.
Similarly, in the X axis moving mechanism 123, too, the moving element is slowed down rapidly, and is stopped at an X axis right side origin position. This constitutes an other side edge origin returning control step.

Subsequently, the above-mentioned acceleration step of the moving element in the Y axis moving mechanism 124 and the acceleration step of the moving element in the X axis moving mechanism 123 are carried out again. That is, an other side edge acceleration control step is carried out. Here, note that a step composed in combination of the above-mentioned other side edge origin returning control step and the other side edge acceleration control step constitutes an other side edge irradiation position alignment control step in which the head 110, being controlled to move in the reverse direction opposite to the direction of conveyance of the substrate 101 at the other side edge of the layer 102 to be processed of the substrate 101, is moved in such a manner that a beam emitted from a beam emitting part which becomes the most forward side in the direction of conveyance of the head 110 can be irradiated to a position of the substrate 101 being conveyed which is apart a predetermined distance from a portion thereof processed by a beam emitting part (objective optical device 113) which becomes the most rear side in the direction of conveyance of the head 110 in the forward direction uniform speed processing control step.
Here, note that the direction of movement of the moving element in the X axis moving mechanism 123 becomes opposite to that in the above-mentioned acceleration step.
In addition, the speed of movement of the moving element in the Y axis moving mechanism 124 becomes the predetermined speed SK, and the speed of movement of the moving element in the X axis moving mechanism 123 becomes the predetermined speed SX. Also, the beam irradiation position of the head 110 which has been moved by the head moving device 120 becomes the next beam irradiation starting position of the substrate 101.

At this time, processing in a reverse direction uniform speed processing control step is carried out, which is similar to that in the above-mentioned forward direction uniform speed processing control step except for that only the direction of movement in the X axis direction becomes reverse. That is, the head 110 moves at the predetermined speed SK in the Y axis direction, and moves at the predetermined speed SX in the X axis direction while irradiating laser beams.
Then, when the beam irradiation position of the head 110 arrives at the beam irradiation end position at one side edge of the layer 102 to be processed of the substrate 101, a one side edge origin returning control step similar to the above-mentioned other side edge origin returning control step is carried out. Here, note that in the X axis moving mechanism 123, the origins lie in the right and left, respectively, and the head 110 returns to an origin at the left or right position opposite to that in the previous other side edge origin returning control step.
Here, the head 110 returns to the first left origin position of the X axis moving mechanism 123.
Then, groove processing can be further continued by returning the head 110 to the above-mentioned first state and by repeating the above-mentioned steps. Here, note that a step composed in combination of this one side edge origin returning control, step and the first one side edge acceleration control step constitutes a one side edge irradiation position alignment control step similar to the above-mentioned other side edge irradiation position alignment control step. Also, note that in the other side edge irradiation position alignment control step and the one side edge irradiation position alignment control step, the left and right positions in the X axis direction are reversed to each other.

According to the beam processing method using the beam processing apparatus as referred to above, by moving the head 110 in the manner as described above, the grooves can be formed in the layer 102 to be processed in a stripe shaped manner without stopping the conveyance of the substrate 101, so the period of operation or work can be shortened to a large extent in the production of the above-mentioned power generation system, etc.
In addition, in the conveyance mechanism 104 for the substrate 101, acceleration, deceleration and stopping are not frequently repeated, so even if the substrate 101 to be conveyed is large in size and weight, large strength is not required for the conveyance mechanism 104, and a reduction in the cost of the conveyance mechanism 104 can be made.
Also, a large load can be prevented from being applied to the substrate 101 being conveyed.

In addition, laser beams can be irradiated perpendicularly to the substrate 101, while moving the head 110 along the shape as shown by the outer periphery of a bow tie, so when processing is performed by irradiating the laser beams to the layer to be processed at one surface side of the substrate 101 from the other surface side thereof, for example, in comparison with the case in which laser beams are irradiated diagonally by the use of a galvanometer mirror and the angle of irradiation of the laser beams changes, there is no change in the reflectance or the angle of irradiation due to the index of refraction on an interface between the substrate 101 and air or other gas, which becomes a surrounding atmosphere, for example, and hence it becomes possible to perform precise and substantially constant processing, as a result of which in the production of the above-mentioned power generation system, an improvement in the power generation efficiency can be expected.

Moreover, as a result of this, a further reduction in the time of processing can be made.
Also, in cases where it is constructed such that a lot of linear processing in a stripe shape can be carried out at narrow intervals in a repeated manner, the speed of movement in the X axis direction of the head 110 or the speed of movement in the Y axis direction in the case of the above-mentioned deceleration and origin returning step need be sufficiently fast with respect to the speed of conveyance of the substrate 101. However, for example, in cases where the speed of conveyance of the substrate 101 is set to be constant, by processing a plurality of grooves with the use of a plurality of laser beams at one time, the period of time required for the reduction in the speed of movement in the X axis direction of the head 110, or the period of time required for deceleration, stopping and acceleration in the Y axis direction thereof can be made longer, as a consequence of which a reduction in the cost of the head moving device 120 can be made.

Further, on the contrary, it also becomes possible to further shorten the time of processing by making the speed of conveyance of the substrate 101 faster.
In addition, in a beam processed substrate in such a beam processing apparatus produced according to the beam processing method, it is possible to reduce the cost of production equipment due to the cost reduction of the above-mentioned beam processing apparatus as well as to reduce the cost due to the shortening of the production time. Thus, even if the reduction of the costs is made, it becomes possible to obtain a beam processed substrate with high quality by means of precise and stable beam processing, and for example, in cases where the beam processed substrate thus obtained is applied to the panels of a power generation system making use of a photoelectric effect, it is possible to provide high power generation efficiency.

Furthermore, the beam irradiation position of the head 110 moves in the shape of a bow tie, so the slit part, which is formed in the stage 141 with the suction unit being arranged therein, corresponds to the entire bow tie-like beam irradiation position, for example.
In addition, when the beam irradiation position is moved in the shape of a bow tie as described above, a galvanometer mirror may be used. Also, at that time, an fθ lens can be used. In this case, in cases where beams are incident diagonally on the substrate 101, because the layer 102 to be processed is arranged on a surface of the substrate 101 at the opposite side of a surface thereof to which the beams are incident, there will be a deviation in beam irradiation positions between the surface to which the beams are incident and the surface on which the layer 102 to be processed is formed, due to the differences in the angle of incidence and in the index of refraction between these surfaces. Accordingly, when the beam irradiation position is moved by means of the galvanometer mirror, it is necessary to enhance the accuracy of the beam irradiation position at the side of the layer 102 to be processed, so it is necessary to adjust the beam irradiation position based on the angle of incidence of the beams to the substrate 101, the index of refraction of the substrate 101, and the index of refraction of an atmospheric gas around the substrate 101.

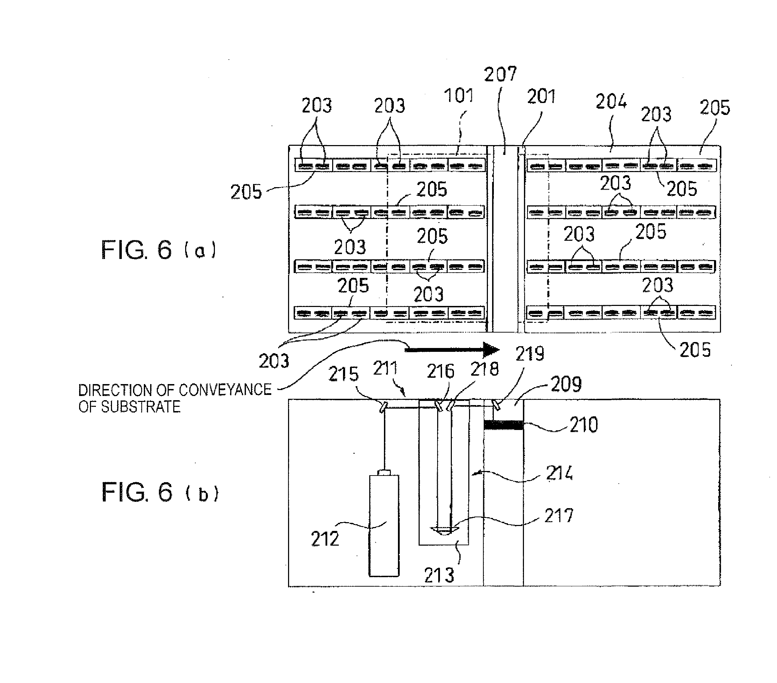

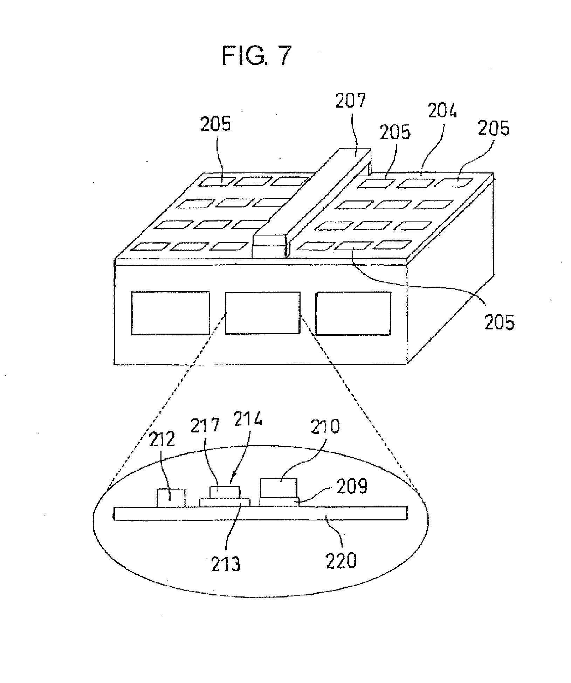

Fig. 6(a), (b) and Fig. 7 explain the schematic construction of a beam processing apparatus according to a third embodiment of the present invention.
In the first and second embodiments, laser is irradiated on the substrate 2 (101) from above, with the layer 3 (102) to be processed side of the substrate 2 (101) being arranged downwards, but in contrast to this, in the third embodiment, it is constructed such that laser is irradiated on the substrate 101 from below, with a side of the substrate 101 near the layer 102 to be processed (illustrated in Fig. 4) being arranged upwards.

In the third embodiment, the structure of a conveyance mechanism 204 is different from that in the first and second embodiments, and in addition, this third embodiment is further different from the first and second embodiments in the following features. That is, a head 210 of a beam irradiation unit is arranged below the substrate 101 on the conveyance mechanism 204, and at the same time, a moving mechanism for the head 210 and a beam guiding system for guiding laser beams to the head 210 are arranged below the substrate 101 on the conveyance mechanism 204. However, the same beam irradiation unit (beam irradiation device 211) as that in the first embodiment or the second embodiment can be used except for such a positional relationship with respect to the substrate 101.
The beam processing apparatus of the third embodiment can be used for the same purpose as the first and second embodiments, and is able to carry out similar processing. This beam processing apparatus can produce a power generation system which makes use of a photoelectric effect, as in the first embodiment.

The conveyance mechanism 204 of the third embodiment is not provided with the gas floating mechanism 10, but is provided with rollers 203 as a support unit. In addition, the rollers 203 are supported for free rotation by roller support members 205, respectively. Also, the rollers 203 are each arranged with the center of rotation thereof being directed orthogonal to the direction of conveyance of the substrate 101 by the conveyance mechanism 204, and serve to support the substrate 101 for free movement along the direction of conveyance thereof.

In addition, the rollers 203 are arranged in a plurality of rows along the direction of conveyance of the substrate 101, and at the same time, are also arranged in a plurality of rows along the width direction orthogonal to the direction of conveyance, so that they support the substrate 101 from below so as to prevent downward bending of the substrate 101.
That is, the conveyance mechanism 204 serves to support the substrate 101 in such a manner that the substrate becomes a flat or level state. Here, note that instead of arranging the rollers 203 in a plurality of rows in the width direction of the substrate 101 (in the direction orthogonal to the direction of conveyance of the substrate 101), the rollers 203 may be of the structure that they have about the same length as that of the substrate 101 so as to prevent bending of the substrate 101.

The rollers 203 are in contact with an under surface of the substrate 101, but the substrate 101 are arranged on the conveyance mechanism 204 with the layer 102 to be processed being directed upwards, so the layer 102 to be processed does not contact the rollers 203, and hence the layer 102 to be processed is not damaged by contact with the rollers 203. Here, note that these rollers 203 have all the upper end portions thereof arranged in one substantially horizontal plane, and are in a state of supporting the substrate 101 in a flat or level manner almost without bending or sagging it.

Moreover, the rollers 203 basically only support the substrate 101 so as to be movable in the direction of conveyance, similar to the gas floating mechanism 10, and the movement of the substrate 101 is carried out by means of an unillustrated moving mechanism, as in the first and second embodiments. The conveyance mechanism is, for example, the same as the moving mechanism 14 of the gas floating mechanism in the first embodiment.
Also, the conveyance mechanism 204 is provided with a slit part 201, as in the gas floating mechanism 10. The slit part 201 is orthogonal to the direction of conveyance of the substrate 101, and has a length about equal to or more than the width of the substrate 101.

Then, below the slit part 201, the head 210 is arranged so as to be freely movable in the Y axis direction, which is the direction of conveyance of the substrate 101, as well as in the X axis direction which is orthogonal to the direction of conveyance, as will be described later.
In addition, above the slit part 201, a suction unit 207 is arranged which has substantially the same construction as that of the first embodiment. This suction unit 207 constitutes a powder removing unit in the third embodiment.

Although the suction unit 207 is the same as that of the first embodiment, it performs suction or drawing by getting closer to the layer 102 to be processed of the substrate 101 from above the substrate 101, but not from below the substrate 101. The suction unit 207 is arranged above the above-mentioned slit part 201. Also, the suction unit 207 is arranged so as to cover the entire portion of the layer 102 which is to be beam-processed by irradiation of laser beams from below in the slit part 201. As a result of this, powder (particulate matter) generated by the laser beam irradiation as stated above is sucked and removed, so it is possible to prevent the particulate matter from readhering to the layer 102 to be processed of the substrate 101, or to prevent the layer 102 to be processed from being put into a dirty state. Here, note that the suction unit 207 is arranged in a fixed manner so as to be able to suck powder over the entire range of movement of the head 210 (the range in which the substrate 101 receives laser irradiation in the conveyance mechanism 204), but the suction unit 207 may be moved in accordance with the movement of the irradiation position of the laser.

The beam irradiation device 211 in the third embodiment is basically the same as the beam irradiation device 111 of the second embodiment, and is provided with a light source device 212 for generating laser beams, and a beam guiding system that guides the laser beams from the light source device 212 to the head 210.

Describing the beam guiding system based on schematic diagrams shown in Fig. 6 and Fig. 7, a laser beam irradiated along the X axis direction from the light source device 212 is turned into the Y axis direction by means of a mirror 215, so that it is put into a state of being introduced into an optical path length adjusting device 214 similar to the optical path length adjusting device 114 of the second embodiment. The laser beam introduced into the optical path length adjusting device 214 is changed in direction from the Y axis direction into the X axis direction by means of a mirror 216. A retroreflector 217 of the optical path length adjusting device 214 is arranged at a location forwardly of the mirror 216 in the X axis direction, so as to be freely movable in the X axis direction. The retroreflector 217 is supported on an optical path length adjustment stage 213 so as to be freely movable in the X axis direction.

The retroreflector 217 is provided instead of two mirrors 117, 117 of the optical path length adjusting device 114 of the first embodiment, and is designed such that when light is incident thereto from a predetermined direction, it reflects the light and emits it in parallel to the incident light. Then, the optical path length of the laser beam is kept substantially constant by moving the retroreflector 217 in the direction of the light incident thereto (the light to be emitted) in accordance with the movement of the retroreflector 217.

The light emitted from the retroreflector 217 is irradiated on a mirror 219 through a mirror 218, and the mirror 219 irradiates the light to the head 210 along the X axis direction.
The head 210 is supported on an X axis stage 209 arranged below the slit part 201 of the conveyance mechanism 204, in such a manner that it is freely movable in the X axis direction.
Although the head 210 moves along the X axis direction below the slit part 201 of the conveyance mechanism 204, the state of the laser beam being irradiated from the mirror 219 to this head 210 is held.
In addition, the beam irradiation device 211 comprised of these component elements is in a state of being received in the interior of the conveyance mechanism 204, while being arranged on a base 220, and the X axis stage 209, which serves to move the head 210 in the X axis direction as described above, is arranged just under the slit part 201 of the conveyance mechanism 204.

Here, note that the head 210 is movable by a slight distance in the Y axis direction, too, as in the above-mentioned second embodiment, but in Fig. 6 and Fig. 7, the construction to move the head 210 in the Y axis direction is omitted. In addition, the head 210 may also be one which irradiates a plurality of laser beams simultaneously. In this case, the laser beams are in a state of being arranged in a row in the Y axis direction.
A beam processing method in the beam processing apparatus of this example is carried out similarly to the first embodiment or the second embodiment except for the features that the substrate 101 has the layer 102 to be processed being directed upwards, and that the head 210 is arranged below the substrate 101 and irradiates a laser beam in an upward direction from below the substrate 101.

That is, similar to the first embodiment, the conveyance mechanism 104 is made in a state of stopping and conveying the substrate 101 in a repeated manner, so that grooves can be formed in the layer 102 to be processed of the substrate 101 in a stripe shape by irradiating a laser beam while moving it in a direction orthogonal to the direction of conveyance of the substrate 101, with the substrate 101 being stopped.

In addition, similar to the second embodiment, it may also be constructed such that the irradiation position of a laser beam by the head 210 is moved in the shape of a bow tie, as described above, in synchronization with the conveyance of the substrate 101 in a state in which the substrate 101 is being conveyed at a constant speed by means of the conveyance mechanism 104.
In this example, by arranging the substrate 101 with the layer 102 to be processed being directed upwards, the substrate 101 can be supported from below without damaging the layer 102 to be processed, thereby making it possible to prevent bending of the substrate 101. Moreover, by irradiating the laser beam from below the substrate 101, processing of the layer 102 to be processed can be carried out by the laser beam which has passed through the substrate 101.

Accordingly, by supporting the substrate 101 from below, laser processing can be carried out with the substrate 101 being held flat, so it is possible to obtain substantially the same operational effects as those in the first embodiment.
In addition, if the layer 102 to be processed is arranged upwards, there is a possibility that the powder generated by the processing of the layer 102 to be processed may adhere to the substrate 101, but by sucking and removing the power from above the substrate 101, it is possible to prevent the powder generated by the processing of the layer 102 to be processed from adhering to the substrate 101.
As a result of this, even in cases where the layer 102 to be processed at the upper surface side of the substrate 101 is processed from below the substrate 101, it is possible to process the layer 102 to be processed without causing any problem.
Moreover, by using the same beam processing method as in the second embodiment, the same operational effects as those in the second embodiment can be achieved.
Here, note that the members for supporting the lower side of the substrate 101 may be anything that is able to prevent bending of the substrate 101, and is smoothly movable in the direction of conveyance without damaging the substrate 101, and for example, they may be a structure in which the substrate 101 is conveyed by means of a belt.

### EXPLANATION OF REFERENCE NUMERALS

- 2: Glass substrate (Substrate)
- 3: Layer to be processed
- 10: Gas floating mechanism
- 11: Stage
- 11c: Slit part
- 12: Gas ejection plate (Gas ejection mechanism)
- 13: Suction unit
- 16: Powder removing unit
- 50: Beam irradiation unit
- 101: Substrate
- 102: Layer to be processed
- 110: Head
- 111: Beam irradiation device (Beam irradiation unit)
- 112: Light source device
- 120: Head moving device
- 123: X axis moving mechanism
- 124: Y axis moving mechanism
- 104: Conveyance mechanism (Moving mechanism)
- 141: Stage
- 203: Rollers (Support unit)
- 204: Conveyance mechanism
- 207: Suction unit (Powder removing unit)
- 210: Head
- 211: Beam irradiation device (Beam irradiation unit)
- 212: Light source device

## Claims

1. A beam processing apparatus in which a beam is irradiated to a layer to be processed which is formed on one surface of a substrate, thereby to process the layer to be processed, **characterized by** comprising:
a gas floating mechanism that supports the substrate in a flatly floated state by ejecting a gas; and
a beam irradiation unit that irradiates a beam to the layer to be processed which is formed on one surface of the substrate, thereby to process the layer to be processed;
wherein the substrate is arranged on the gas floating mechanism with one surface of the substrate on which the layer to be processed is formed being directed downwards, and processing is applied to the layer to be processed by irradiating a beam on the layer to be processed through the substrate by means of the beam irradiation unit from above the other surface of the substrate.

2. The beam processing apparatus as set forth in claim 1, **characterized in that**
the gas floating mechanism is provided with a stage that has a gas ejection mechanism for ejecting a gas, and supports the substrate by floating it in a flat state, and a moving mechanism that moves the substrate in at least one direction on the stage;
the beam irradiation unit has an irradiation position of the beam which is made reciprocatable along one direction intersecting one direction of movement of the substrate;
the stage is provided with a powder removing unit that sucks powder generated by the processing of the layer to be processed by beam irradiation in a range of movement of the irradiation position of the beam irradiated by the beam irradiation unit; and
the powder removing unit is provided with a slit part that makes the stage into a cut-off state in a portion thereof including a range of reciprocation of the beam irradiation position, and a suction unit that sucks the powder from the slit part.

3. The beam processing apparatus as set forth in claim 1 or 2, **characterized in that**
the gas floating mechanism is provided with a stage that has a gas ejection mechanism for ejecting a gas, and supports the substrate by floating it in a flat state, and a moving mechanism that moves the substrate in one direction on the stage;
the beam irradiation unit moves the beam irradiation position in a direction along the direction of movement of the substrate in synchronization with the movement of the substrate at the time of processing the layer to be processed of the substrate, and moves the beam irradiation position in a direction intersecting the direction of movement of the substrate; and
the layer to be processed of the substrate is processed by the beam irradiation by means of the beam irradiation unit in a state where the substrate is moved by means of the moving mechanism.

4. A beam processing apparatus in which a beam is irradiated to a layer to be processed which is formed on one surface of a substrate, thereby to process the layer to be processed, **characterized by** comprising:
a conveyance mechanism that is provided with a support unit for supporting the substrate from below so as to make the substrate in a substantially flat state, and moves the substrate in one direction in a state where the substrate is supported by the support unit;
a beam irradiation unit that irradiates a beam to the layer to be processed which is formed on one surface of the substrate, thereby to process the layer to be processed; and
a powder removing unit that sucks powder generated by the processing of the layer to be processed by the beam irradiation;
wherein the substrate is arranged on the conveyance mechanism with one surface of the substrate on which the layer to be processed is formed being directed upwards, and processing is applied to the layer to be processed by irradiating a beam on the layer to be processed through the substrate by means of the beam irradiation unit from below the other surface of the substrate; and
the powder removing unit sucks and removes, from above the substrate, the powder generated by the processing of the layer to be processed by the beam irradiation.

5. A beam processing method in which a beam is irradiated to a layer to be processed which is formed on one surface of a substrate thereby to process the layer to be processed, **characterized by** comprising:
processing the layer to be processed by the beam through the substrate by irradiating the beam from above another surface of the substrate opposite to a surface thereof on which the layer to be processed is formed, in a state where the substrate is caused to float in a flat manner with the layer to be processed being directed downwards by means of a gas ejected from below.

6. A beam processing method in which a beam is irradiated to a layer to be processed which is formed on one surface of a substrate, thereby to process the layer to be processed, **characterized by** comprising:
processing the layer to be processed through the substrate by the beam by irradiating the beam from below another surface of the substrate opposite to a surface thereof on which the layer to be processed is formed, in a state where the substrate is supported from below so as to be substantially flat with the layer to be processed being directed upwards, and
sucking and removing powder generated by the processing of the layer to be processed by the beam from above the substrate.

7. A beam processed substrate **characterized by** having a layer to be processed which has been processed by the beam processing apparatus as set forth in any one of claims 1 through 4.
